## Europäisches Patentamt

## European Patent Office

## Office européen des brevets

(19)

(11) Veröffentlichungsnummer : **0 166 817**
**B1**

(12) **EUROPÄISCHE PATENTSCHRIFT**

(45) Veröffentlichungstag der Patentschrift :
19.08.87

(51) Int. Cl.⁴ : **H 01 R 43/02**, B 23 K 1/08

(21) Anmeldenummer : **84115352.1**

(22) Anmeldetag : **13.12.84**

(54) **Verfahren und Vorrichtung zum Verlöten von Anschlussdrähten von elektrischen Bauteilen sowie Anordnung aus elektrischen Bauteilen.**

(30) Priorität : **07.06.84 DE 3421280**

(43) Veröffentlichungstag der Anmeldung :
**08.01.86 Patentblatt 86/02**

(45) Bekanntmachung des Hinweises auf die Patenterteilung : **19.08.87 Patentblatt 87/34**

(84) Benannte Vertragsstaaten :
**DE FR GB IT NL SE**

(56) Entgegenhaltungen :
**DD-B- 0 153 512**
**DE-A- 2 740 139**
**DE-A- 3 036 197**

(73) Patentinhaber : **Roederstein Spezialfabriken für Bauelemente der Elektronik und Kondensatoren der Starkstromtechnik GmbH**
**Ludmillastrasse 23/25**
**D-8300 Landshut (DE)**

(72) Erfinder : **Mayer, Harald**
**Carossastrasse 7**
**D-8359 Eging (DE)**

(74) Vertreter : **Patentanwälte Viering & Jentschura**
**Steinsdorfstrasse 6**
**D-8000 München 22 (DE)**

Jouve, 18, rue St-Denis, 75001 Paris, France

**Beschreibung**

Die Erfindung betrifft ein Verfahren zum gegenseitigen Verlöten von Anschlußdrähten von elektrischen Bauteilen, bei welchem jeweils die miteinander zu verlötenden Anschlußdrähte als Anschlußdrahtgruppen, in welchen die Anschlußdrähte mit ihren freien Enden in die gleiche Richtung weisen, gemeinsam in enger gegenseitiger Anordnung in ein Bad aus schmelzflüssigem Lot getaucht werden und das Löten unter Ausnützung der Kapillarwirkung in Kapillarspalten erfolgt.

Ferner betrifft die Erfindung eine Vorrichtung zum gegenseitigen Verlöten der Anschlußdrähte von elektrischen Bauteilen, die auf einem Bauteilträger vormontiert sind und die mit ihren jeweiligen miteinander zu verlötenden Anschlußdrähten als Anschlußdrahtgruppe zusammengehalten sind, zur Durchführung des Verfahrens, mit einem Schmelzenbehälter zur Aufnahme eines Bades aus schmelzflüssigem Lot und mit einer Haltevorrichtung für den Bauteilträger.

Außerdem betrifft die Erfindung eine Anordnung aus elektrischen Bauteilen, deren Anschlußdrähte mit ihren Drahtenden in die gleiche Richtung weisen und in Anschlußdrahtgruppen nach dem Verfahren verlötet sind.

Es ist eine Anordnung von elektrischen Bauteilen in Form einer Spannungsvervielfacherbaugruppe aus zu einer Kaskadenschaltung zusammengeschalteten Kondensatoren und Dioden bekannt (DE-A-2 430 666), bei welcher die elektrischen Bauteile auf Leiterplatten montiert sind und ihre Anschlußdrähte mittels Tauchlöten mit den auf den Leiterplatten vorhandenen Leiterbahnen verlötet wurden. Bei einem derartigen Verlöten können jedoch aus dem Lötbad stammende Lotperlen oder Lotbrücken entstehen, die unbeabsichtigt sind und von welchen spannungführende Teile, die an sich nicht elektrisch verbunden sein sollen, miteinander elektrisch verbunden werden oder für die der Isolationsabstand zwischen ihnen unzulässig verkleiner wird.

Um derartige Gefahren der Betriebsstörung der Bauteilanordnung insbesondere beim Betrieb mit hohen Spannungen auszuschließen, können die elektrischen Verbindungen statt durch Löten durch Verschweißen hergestellt werden. Hierzu ist es bekannt (DE-B-2 835 554), die elektrischen Bauteile für das Schweißen mittels sie lagerichtig fixierender Klemmaufnahmen auf der einen Flachseite eines aus Kunststoff bestehenden Bauteilträgers festzulegen. Solche lagefixierenden Klemmaufnahmen sind jedoch bauaufwendig und es ergeben sich beim Verschweißen der elektrischen Bauteile vor allem dann Schwierigkeiten, wenn mehr als zwei der elektrischen Bauteile miteinander verbunden werden sollen. Ferner ist die für eine rationelle Fertigung erforderliche Schweißvorrichtung zum gleichzeitigen Schweißen von mehreren Schweißstellen aufwendig.

Die Merkmale aus dem einleitenden Teil der Ansprüche 1, 2, 8, und 10 sind ebenfalls bekannt (DD-B-0 153 512). Dort besteht der Bauteilträger für das Tauchlöten aus einem nicht-lötfähigen Material und wird die Kapillarwirkung in den Kapillarspalten zwischen den Anschlußdrähten und der Wandung des Loches des Bauteilträgers, durch welches sie hindurchgesteckt sind, zum Hineinsaugen des Lotes in das Loch ausgenutzt. Entsprechend wird der plattenförmige Bauteilträger teilweise ebenfalls in das Lotbad eingetaucht und nach dem Löten von den verlöteten Anschlußdrähten getrennt.

Durch die Erfindung wird die Aufgabe gelöst, ein Verfahren und eine Vorrichtung zum Verlöten von Anschlußdrähten elektrischer Bauteile sowie eine Anordnung aus elektrischen Bauteilen derart zu gestalten, daß mit geringem Aufwand ein einwandfreies gegenseitiges Verlöten auch mehr als zweier Anschlußdrähte im Tauchlötverfahren ohne eine Gefahr von späteren Betriebsstörungen durch Kurzschlüsse oder durch eine unzureichende Spannungsfestigkeit ermöglicht ist.

Dies wird gemäß der Erfindung bei dem Verfahren der eingangs erwähnten Art dadurch erreicht, daß die Anschlußdrähte ausschließlich mit ihren freien Drahtenden in das Bad eingetaucht werden und das Lot in den Kapillarspalten, die aufgrund der engen gegenseitigen Anordnung der Anschlußdrähte zwischen diesen ausgebildet werden, aus dem Bad gesaugt und in den Bereich der Anschlußdrähte über dem Bad zwischen die Anschlußdrähte getrieben wird.

Durch die Erfindung können aufgrund der Ausnutzung der Kapillarwirkung selbst dünne Drähte mit Rundquerschnitt über einen Längenabschnitt hin, der mehrfach größer als die Tiefe ihres Eintauchens in das Lötbad ist, einwandfrei miteinander verlötet werden. Die Länge des Längenabschnittes, über den hin die Anschlußdrähte aufgrund der Erfindung verlötet werden können, kann vergrößert werden, wenn vor dem Eintauchen der Enden der Anschlußdrähte in das Lötbad die Anschlußdrahtenden in ein flüssiges Lötflußmittel eingetaucht werden, welches dann ebenfalls unter den Kapillarkräften zwischen die Anschlußdrähte gesaugt wird.

Es hat sich ferner gezeigt, daß das flüssige Lot durch die Kapillarwirkung auch zwischen zu verlötende Anschlußdrähte getrieben wird, die innerhalb einer Materialbohrung verlaufen, so daß die Anschlußdrähte nur mit ihrem freien Ende, das aus der Materialbohrung herausragt, gemeinsam in das Lotbad eingetaucht zu werden brauchen und dennoch innerhalb der Bohrung miteinander verlötet werden.

Bevorzugt werden daher die elektrischen Bauteile für das Verlöten ihrer Anschlußdrähte in an sich bekannter Weise (DD-B-0 153 512) auf der einen Flachseite eines Bauteilträgers angeordnet und die Anschlußdrähte der Anschlußdrahtgruppe gemeinsam durch ein Loch des Bauteilträgers über dessen anderen Flachseite hinausstehend gesteckt und dadurch in der engen gegenseitigen Anordnung für das Eintauchen der über die andere Flachseite des Bauteilträgers hinausstehenden Drahtenden in das Bad gehalten. Gemäß der Erfindung jedoch erfolgt das Eintauchen der freien Enden der Anschlußdrähte in das Lotbad im Abstand unter dem Bauteilträger und wird das Lot unter der Kapillarwirkung bis in das Loch des Bauteilträgers hineingetrieben. Durch das Hindurchstecken der Anschlußdrähte der Bauteile durch entsprechend enge Löcher des Bauteilträgers werden die elektrischen Bauteile gleichzeitig lagerichtig auf dem Bauteilträger fixiert, so daß zusätzliche Vorrichtungen auf dem Bauteilträger, wie Klemmaufnahmen oder dergleichen, entfallen können. Da außerdem das Lötmaterial in das enge Loch im Bauteilträger eindringt, obwohl der Bauteilträger selbst nicht in das Lotbad eingetaucht wird, werden die Bauteile an ihren Anschlußdrähten zusätzlich auf dem Bauteilträger fixiert.

Bei dem erfindungsgemäßen Verfahren können die Anschlußdrahtgruppen gleichzeitig in ein gemeinsames Lotbad eingetaucht werden. Wenn jedoch die elektrischen Bauteile auf einem Bauteilträger angeordnet sind, über welchen hin die Anschlußdrahtgruppen im Abstand voneinander verteilt angeordnet sind, werden die Bereiche des Bauteilträgers, die zwischen den Anschlußdrahtgruppen liegen, einer verhältnismäßig hohen Wärmeabstrahlung aus dem Lotbad ausgesetzt. Gleichwohl kann dies in weiterer Ausgestaltung der Erfindung vermieden werden, indem beim Verlöten der Anschlußdrähte innerhalb von mehreren Anschlußdrahtgruppen diese gleichzeitig in gesonderte Lotbadteile eines gemeinsamen Lotbades getaucht werden und diejenigen Materialbereiche des Bauteilträgers, die zwischen den Anschlußdrahtgruppen liegen, gegen Wärmestrahlung aus dem Lotbad abgeschirmt werden. Hierbei kann somit die Lotbadoberfläche gegen den Bauteilträger hin mit einer wärmedämmenden Platte abgedeckt sein, in welcher lediglich an den Orten der Anschlußdrahtgruppen Öffnungen vorhanden sind, über welche das Lotbad zu dem Bauteilträger hin freiliegt und durch welche hindurch die Anschlußdrahtgruppen in das Lotbad eingetaucht werden. Dieser Vorschlag basiert auf einem weiteren Vorteil der Erfindung, der darin liegt, daß aufgrund der Erfindung nur örtlich über den Bauteilträger hin verteilte Stellen erforderlich sind, wo Lötwärme aufgebracht zu werden braucht. Trotz des verwendeten Tauchlötverfahrens kann daher für den Bauteilträger ein Kunststoffmaterial geringer Warmfestigkeit verwendet werden, ohne daß ein Schmelzen des Kunststoffmaterials beim Löten zu befürchten ist.

Der gleiche Vorteil wird bei einer gegenwärtig besonders bevorzugten Ausgestaltung des erfindungsgemäßen Verfahrens dadurch erreicht, daß beim Verlöten der Anschlußdrähte innerhalb von mehreren Anschlußdrahtgruppen diese gleichzeitig in voneinander getrennte Lotbäder eingetaucht werden. Diese räumlich voneinander getrennten Lotbäder brauchen nur eine sehr kleine Masse zu haben, so daß von ihnen eine nur minimale Wärmeabstrahlung ausgeht, die außerdem weitestgehend auf die Orte der Anschlußdrahtgruppen beschränkt ist. Diese Ausgestaltung der Erfindung bietet darüberhinaus den besonderen Vorteil, daß zwischen den voneinander getrennten Lotbädern ein Freiraum freigehalten werden kann und an der Unterseite des Bauteilträgers im Abstand von den Anschlußdrahtgruppen nach unten ragende Vorsprünge und Ansätze vorhanden sein können, die beim Eintauchen der Enden der Anschlußdrahtgruppen in die Lotbäder in diesen Freiraum eintauchen können, ohne selbst in das Lotbad eintauchen zu müssen.

Solche Vorsprünge und Ansätze können beispielsweise zur Befestigung der Bauteilgruppe in einem Gehäuse oder auf einer Montageplatte oder dergleichen vorteilhaft sein, wobei durch diese Ausgestaltung der Erfindung dafür gesorgt ist, daß sie dennoch beim Tauchlöten der Anschlußdrähte der elektrischen Bauteile nicht stören. Aus entsprechendem Grund können die Anschlußdrahtgruppen, sofern mit einem Lötflußmittel gearbeitet wird, vor dem Lötvorgang gleichzeitig in voneinander getrennte Flußmittelbäder getaucht werden.

Im Sinne der Erfindung können die Anschlußdrähte der elektrischen Bauteile auch mit einzelnen Drahtstücken nach dem erfindungsgemäßen Verfahren verlötet werden. Wenn beispielsweise zwei elektrische Bauteile in einem solchen Abstand voneinander angeordnet sind, daß ihre miteinander zu verbindenden Anschlußdrähte nicht zusammengeführt werden können, können die beiden Anschlußdrähte über ein Verbindungsdrahtstück miteinander verbunden werden, das nach dem erfindungsgemäßen Verfahren mit den Anschlußdrähten verlötet wird. Hierzu wird das Verbindungsdrahtstück mit seinen beiden Endabschnitten in derartiger Lage an den Endabschnitt jeweils eines der Anschlußdrähte angesetzt, daß die freien Enden des Verbindungsdrahtstückes in die gleiche Richtung wie diejenigen der beiden Anschlußdrähte weisen, und in dieser Lage mit den Anschlußdrähten verlötet. Entsprechend kann vor dem Anlöten eines Drahtstückes an einen Anschlußdraht das Drahtstück mit seinem einen Drahtendabschnitt derart an den freien Endabschnitt des Anschlußdrahtes angesetzt werden, daß dessen freies Ende in die gleiche Richtung wie das freie Ende des Drahtendabschnittes des Drahtstückes weist, wonach das Verlöten der Drähte im Sinne des erfindungsgemäßen Verfahrens durchgeführt wird.

Die für das erfindungsgemäße Verlöten über die den elektrischen Bauteilen abgewendete Flachseite des Bauteilträgers hinausstehenden freien Endabschnitte der Anschlußdrahtgruppen können nach dem Verlöten über diese Flachseite des Bauteilträgers hinausstehend verbleiben. Vorzugsweise werden jedoch diejenigen freien Endabschnitte der Anschlußdrahtgruppen, welche nicht zur Weiterführung eines elektrischen Anschlusses benötigt werden, nach dem Verlöten bis zu der den Bauteilen abgewendeten Flachseite des Bauteilträgers abgetrennt.

Die Bauteilanordnung kann nach dem Verlöten der Anschlußdrähte mitsamt dem Bauteilträger in an sich bekannter Weise mit Gießharz vergossen werden.

Die bevorzugte Vorrichtung der eingangs erwähnten Art zur Durchführung des erfindungsgemäßen Verfahrens weist einen Becherhalter mit mehreren Lötbechern auf, der zwischen einer Lötstellung, in welcher die Anschlußdrahtgruppen von der Unterseite des mittels der Haltevorrichtung gehaltenen Bauteilträgers nach unten vorstehend in jeweils einen der Lötbecher eintauchen, und einer Füllstellung verfahrbar ist, in welcher die Becher für ihr Auffüllen in den Schmelzenbehälter eintauchen. Hierzu ist es an sich bekannt (DE-A-2 740 139), einen in ein Schmelzenbehälter eintauchbaren, höhenbeweglichen Lötbecher z. B. zum Verlöten der Spulendrahtenden eines Spulenkörpers mit dessen Anschlußstiften zu verwenden.

Das Lotbad in dem Schmelzenbehälter ist vorzugsweise ein an sich bekanntes Schwallbad, damit die Lötbecher mit möglichst reinem Lötmaterial ohne Oxidationsverunreinigungen oder dgl. aufgefüllt werden.

Die Lötbecher bestehen aus einem nicht-lötfähigen Material, beispielsweise aus Stahl. Der Becherhalter kann nach Art der bei Förderzeugen bekannten Becherwerke ausgebildet und umlaufend angetrieben sein, wobei die Haltevorrichtung mit dem Bauteilträger mitläuft. Es ist auch möglich, den Becherhalter nach Art einer Wippe auszubilden, die mittels einen entsprechenden Antriebes auf- und abverschwenkbar ist. Gegenwärtig wird es jedoch vorgezogen, den Becherhalter über dem Schmelzenbehälter anzuordnen und mittels einer Hubvorrichtung als Antrieb zwischen der Füllstellung und der Lötstellung vertikal geradlinig verfahrbar auszubilden, wobei der Bauteilträger mittels der Haltevorrichtung frei auskragend im Abstand über dem Schmelzenbehälter gehalten wird (vgl. DE-A-2 740 139).

Wie aus der obigen Erläuterung des erfindungsgemäßen Verfahrens ersichtlich, haben die elektrischen Bauteile, deren Anschlußdrähte nach dem erfingungsgemäßen Verfahren verlötet werden, zur Durchführung der bevorzugten Ausführungsform des erfindungsgemäßen Verfahrens eine ganz charakteristische Anordnung. Diese in eingangs erwähnter Art ausgebildete Anordnung aus elektrischen Bauteilen ist gemäß der Erfindung derart, daß die elektrischen Bauteile auf der einen Seite eines ihnen gemeinsamen Bauträgers angeordnet sind und die verlöteten Anschlußdrahtgruppen in ein die gegenseitige enge Anordnung ihrer Anschlußdrähte bestimmendes Loch in dem Bauteilträger gesteckt sind und Lötmaterial in den Spalten zwischen den Anschlußdrähten innerhalb des Loches angeordnet ist.

Hierbei können zwischen den verlöteten Anschlußdrahtgruppen, wie oben bereits erwähnt, von der den Bauteilen abgewendeten Flachseite des Bauteilträgers abstehende Ansätze oder Vorsprünge vorgesehen sein, die beispielsweise zur späteren Festlegung des Bauteilträgers mitsamt der Bauteilanordnung dienen. Ferner kann die Bauteilanordnung mitsamt dem Bauteilträger, ggf. in einem Gehäuse, mit Gießharz vergossen sein.

In der bevorzugten Ausführungsform der erfindungsgemäßen Bauteilanordnung besteht diese aus zu einer Spannungsvervielfacherkaskade zusammengeschalteten Kondensatoren und Dioden, wobei ggf. am Ausgang der Kaskade Strombegrenzungswiderstände in der Bauteilanordnung vorhanden sein können. Jedoch können die Bauteile auch zu anderen elektrischen Schaltungen zusammengeschaltet sein und andersartige elektrische Bauteile sein. Die Erfindung eignet sich insbesondere in solchen Fällen, in denen sonst Leiterbahnplatten mit elektrischen Bauteilen bestückt werden.

Die Bestückung des Bauteilträgers mit den elektrischen Bauteilen, deren Anschlußdrähte senkrecht zur Längsrichtung der Bauteile ausgerichtet sind, kann in an sich bekannter Weise (DD-B-0 153 512) dadurch begünstigt werden, daß das Loch, durch welches die jeweiligen Anschlußdrähte hindurchgesteckt sind, wenigstens an seinem den Bauteilen zugewendeten Rand konisch oder abgefast ist.

Vorzugsweise steht an der den Bauteilen abgewendeten Flachseite des Bauteilträgers für jede verlötete Anschlußdrahtgruppe ein das Loch umgebender Stutzen ab, wodurch die Wandstärke des Bauteilträgers zwischen den Anschlußdrahtgruppen dünn sein kann und dennoch die Anschlußdrähte der Anschlußdrahtgruppen in den Stutzen über eine größere Länge als diese Wandstärke hin in ihrer für das erfindungsgemäße Verlöten erforderlichen engen Anordnung gehalten werden können. Vorzugsweise sind ferner die Löcher als schlitzartige Langlöcher ausgebildet, in denen die Anschlußdrähte in einer Reihe nebeneinander angeordnet sind.

In der fertigen erfindungsgemäßen Bauteilanordnung enden vorzugsweise die verlöteten Anschlußdrähte der Anschlußdrahtgruppen jeweils an der freien Stirnfläche der Stutzen, so daß sie nicht über diese hinausstehen. Dies wird durch das erfindungsgemäße Verfahren ermöglicht, weil dadurch erreicht werden kann, daß das Lötmaterial beim Löten bis in die die Anschlußdrahtgruppen aufnehmenden Löcher des Bauteilträgers getrieben wird, so daß die für das Verlöten an der den Bauteilen abgewendeten Flachseite des Bauteilträgers vorstehenden Endabschnitte der Anschlußdrahtgruppen nach dem Verlöten bis zu dieser Flachseite des Bauteilträgers hin abgetrennt werden können.

Wenngleich es bevorzugt wird, für jede Anschlußdrahtgruppe ein gesondertes Loch in dem Bauteilträger vorzusehen, ist es ggf. auch möglich, für mehrere Anschlußdrahtgruppen ein gemeinsames Loch in Form eines Schlitzes vorzusehen, in welchem die Anschlußdrahtgruppen im Abstand voneinander an den Schlitzrändern wenigstens bis zum Verlöten reibschlüssig gehalten sind.

Die Erfindung wird anhand von bevorzugten Ausführungsbeispielen, die aus der Zeichnung ersichtlich sind, zusätzlich erläutert. In der Zeichnung zeigt:

Figur 1 eine Anordnung aus elektrischen Bauteilen auf einem Bauteilträger in Draufsicht,

Figur 2 die Seitenansicht der Bauteilanordnung aus Fig. 1,

Figur 3 die Einzelheit A aus Fig. 2 in vergrößertem Maßstab und teilweise im Schnitt,

Figur 4 die Seitenansicht eines anderen Ausführungsbeispiels einer Bauteilanordnung, teilweise im Schnitt,

Figur 5 die Bauteilanordnung aus Fig. 4 entsprechend der darin eingetragenen Schnittlinie V-V,

Figur 6 die Bauteilanordnung aus Fig. 4 entsprechend der darin eingetragenen Schnittlinie VI-VI,

Figur 7 in Seitenansicht, teilweise im Schnitt, eine Vorrichtung zur Durchführung des erfindungsgemäßen Verfahrens beim Verlöten der Anschlußdrahtgruppen einer Anordnung aus elektrischen Bauteilen auf einem Bauteilträger und

Figur 8 die Einzelheit B aus Fig. 7 in vergrößertem Maßstab während des Lötvorganges.

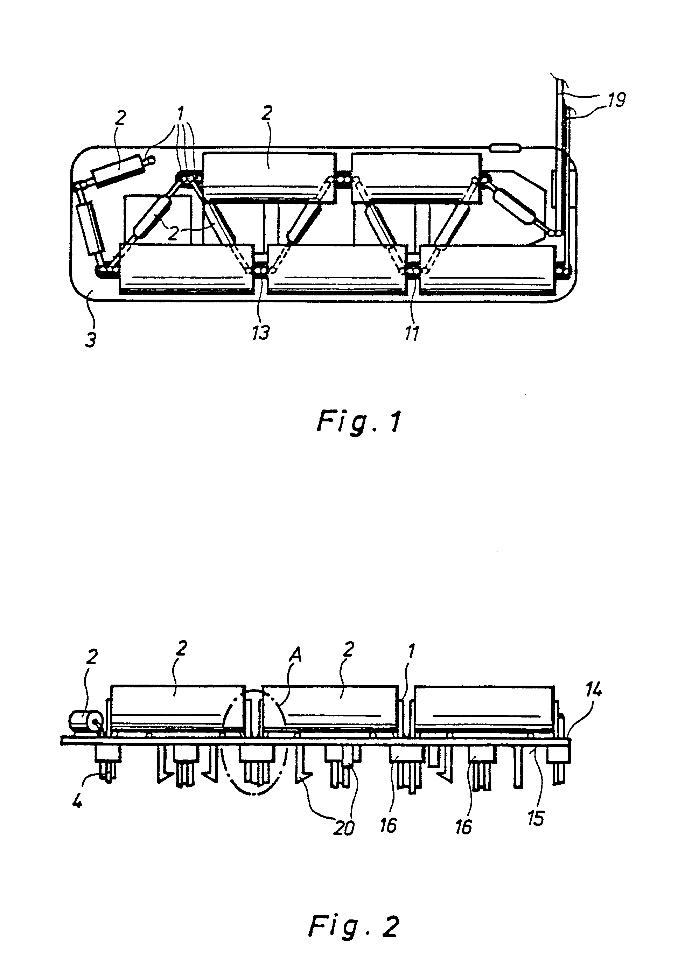

Die Bauteilanordnung gemäß den Fig. 1 bis 3 besteht aus einer auf einem Bauteilträger 3 fixierten Mehrzahl von Kondensatoren, Dioden und Widerständen, die als elektrische Bauteile 2 zu einer Spannungsvervielfacher-Kaskadenschaltung zusammengeschaltet sind. Der Bauteilträger 3 ist als plattenförmiger länglich rechteckiger Rahmen ausgebildet, dessen Rahmenlangseiten über Stege miteinander verbunden sind. Im Ausführungsbeispiel sind fünf Kondensatoren vorgesehen, von denen drei auf der einen Rahmenlangseite, und zwei auf der anderen Rahmenlangseite angeordnet sind. Jeder der Kondensatoren, die als Wickelkondensatoren ausgeführt sind, ist an seinen beiden Stirnseiten mit einer Kontaktschicht versehen, an welcher ein Anschlußdraht 1 in einer derartigen Lage angeschweißt oder angelötet ist, daß die Anschlußdrähte 1 jedes Kondensators in der gleichen Radialebene desselben liegen und über den Kondensatorkörper radial hinausstehen. Außerdem weist die Bauteilanordnung sechs Dioden auf, die zwischen den Langseiten des Bauteilträgers 3 schräg zu dessen Längsachse verlaufend angeordnet sind und deren axial zu den Dioden verlaufenden Anschlußdrähte 1 zu den Anschlußdrähten der zugehörigen Kondensatoren geführt sind und dort parallel zu dem jeweiligen Anschlußdraht der Kondensatoren abgewinkelt sind. Am in Fig. 1 linken Ende des Bauteilträgers 3 sind zwei Widerstände mit axial aus diesen herausgeführten Anschlußdrähten 1 angeordnet, welche ebenfalls senkrecht zur Ebene des Bauteilträgers 3 abgewinkelt sind. Am in Fig. 1 rechten Ende sind zwei Drahtstücke 19 angeordnet, die parallel zur Ebene des Bauteilträgers seitlich aus diesem herausgeführt sind und an ihrem Anschlußende für die Eingangsdiode bzw. den Eingangskondensator ebenfalls senkrecht zur Ebene des Bauteilträgers 3 abgewinkelt sind.

Wie aus den Fig. 1 und 2 ersichtlich, sind daher jeweils zu zwei einander axial benachbarten Kondensatoren zwei Diodenanschlußdrähte zu einer Anschlußdrahtgruppe 4 zusammengefügt, innerhalb welcher die Anschlußdrähte 1 miteinander verlötet werden, wohingegen zu den Anschlußdrähten der in Fig. 1 links angeordneten Kondensatoren zwei Diodenanschlußdrähte bzw. ein Diodenanschlußdraht und ein Widerstandsanschlußdraht zu einer Anschlußdrahtgruppe zusammengeführt sind und die beiden links in Fig. 1 angegebenen Widerstände mit ihren beiden Anschlußdrähten zu einer Anschlußdrahtgruppe 4, sowie am rechten Ende des Bauteilträgers 3 zwei Anschlußdrähte von der Eingangsdiode und dem daran anzuschließenden Drahtstück 19 bzw. dem Eingangskondensator und dem daran anzuschließenden Drahtstück 19 jeweils zu einer Anschlußdrahtgruppe zusammengeführt sind.

Für jede dieser Anschlußdrahtgruppen ist in dem Bauteilträger 3 ein Loch ausgebildet, durch welches die Anschlußdrähte 1 der jeweiligen Anschlußdrahtgruppe 4 hindurchgesteckt sind, so daß sie an der Unterseite des Bauteilträgers 3 nach unten hinausragen. Je nach der Anzahl der miteinander zu verlötenden Anschlußdrähte 1 der jeweiligen Anschlußdrahtgruppe 4, welche bei dem Beispiel aus den Fig. 1 bis 3 parallel zur Längsrichtung des Bauteilträgers 3 hintereinander angeordnet sind, ist das Loch 11 mehr oder weniger lang ausgebildet, so daß die Anschlußdrähte jeder Anschlußdrahtgruppe in enger gegenseitiger Anordnung gehalten sind. Dadurch sind die Bauteile 2 auf dem Bauteilträger 3 für das Verlöten der Anschlußdrähte 1 innerhalb der Anschlußdrahtgruppen 4 vormontiert gehalten.

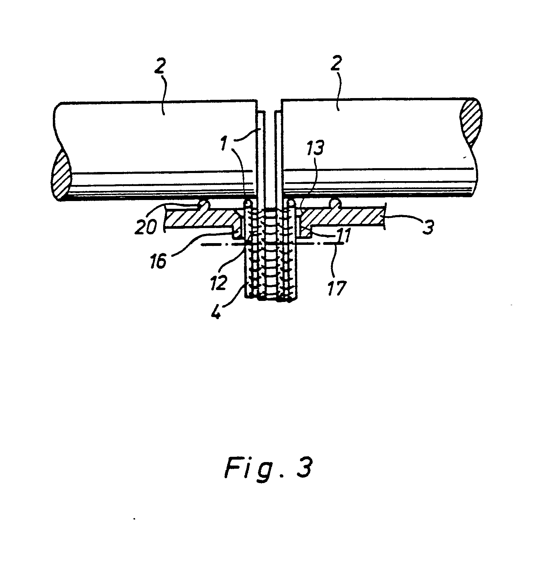

Die Löcher 11 in dem Bauteilträger 3 sind an ihren Lochrändern 13 abgefast, wodurch das Einsetzen der Einschlußdrähte 1 der Bauteile 2 begünstigt wird. Außerdem sind, wie insbesondere aus Fig. 3 ersichtlich, auf der Oberseite des Bauteilträgers 3 beidseitig der Löcher 11 vorspringende Abstandshalterrippen 20 ausgebildet, auf denen die Kondensatorenbauteile 2 aufliegen, so daß die Anschlußdrähte der Diodenbauteile 2 unter den Kondensatorenbauteilen 2 hindurch in das jeweilige Loch 11 des Bauteilträgers 3 eingeführt werden können. Zur Bestückung des Bauteilträgers 3 werden daher zuerst die Anschlußdrähte 1 der Diodenbauteile in das jeweilige Loch 11 eingeführt, wonach die Kondensatorenbauteile 2 aufgesetzt werden und mit ihren jeweiligen Anschlußdrähten 1 ebenfalls in das jeweilige Loch im Bauteilträger 3 eingesteckt werden. Wie insbesondere aus Fig. 3 ersichtlich, sind die Löcher an dem den Bauteilen 2 zugewendeten Lochrand 13 abgefast, wodurch das ggf. automatische Einführen der Anschlußdrähte 1 der Bauteile 2 begünstigt wird.

Die elektrischen Bauteile 2 sind daher sämtlich auf der einen Flachseite 14 des Bauteilträgers 3 angeordnet und stehen mit ihren Anschlußdrähten 1 über die andere Flachseite 15 des Bauteilträgers 3 hinaus, damit sie mit ihren freien Enden in ein Lötbad eingetaucht werden können, so daß — wie aus Fig. 3 ersichtlich — das Lötmaterial 12 durch Kapillarwirkung aufgrund der engen gegenseitigen Anordnung, in welcher die Anschlußdrähte 1 innerhalb jeder Anschlußdrahtgruppe 4 von den Begrenzungswänden der Löcher 11 gehalten sind, bis in den Bereich innerhalb der Löcher 11 hineingesaugt wird. Damit diese enge gegenseitige Anordnung der Anschlußdrähte 1 innerhalb jeder Anschlußdrahtgruppe 4 trotz dünner Wandstärke des Bauteilträgers 3 sichergestellt ist, weist der Bauteilträger 3 für jedes Loch 11 an der den Bauteilen 2 abgewendeten Flachseite 15 des Bauteilträgers 3 einen abstehenden Stutzen 16 auf, durch welchen das jeweilige Loch hindurch verläuft. Da das Lötmaterial 12 bis in den Bereich innerhalb des Loches hineindringt, können die Anschlußdrähte 1 nach ihrem gegenseitigen Verlöten bis zu dem freien Stirnende der Stutzen 16, welches in Fig. 3 durch die strichpunktierte Linie 17 dargestellt ist abgetrennt werden.

An der den Bauteilen 2 abgewendeten Flachseite 15 des Bauteilträgers 3 sind außerdem vorstehende Ansätze 20 ausgebildet, an denen ein zusätzliches elektrisches Bauteil, das aus Funktionsgründen nicht zusammen mit den anderen elektrischen Bauteilen 2 auf der gleichen Flachseite 14 des Bauteilträgers 3 angeordnet sein kann, gehaltert werden kann oder die als Abstandshalter für die Anordnung der Bauteilanordnung in einem Gehäuse (nicht gezeigt) dienen können, in welchem die Bauteilanordnung mit hochspannungsfestem Gießharz vergossen sein kann.

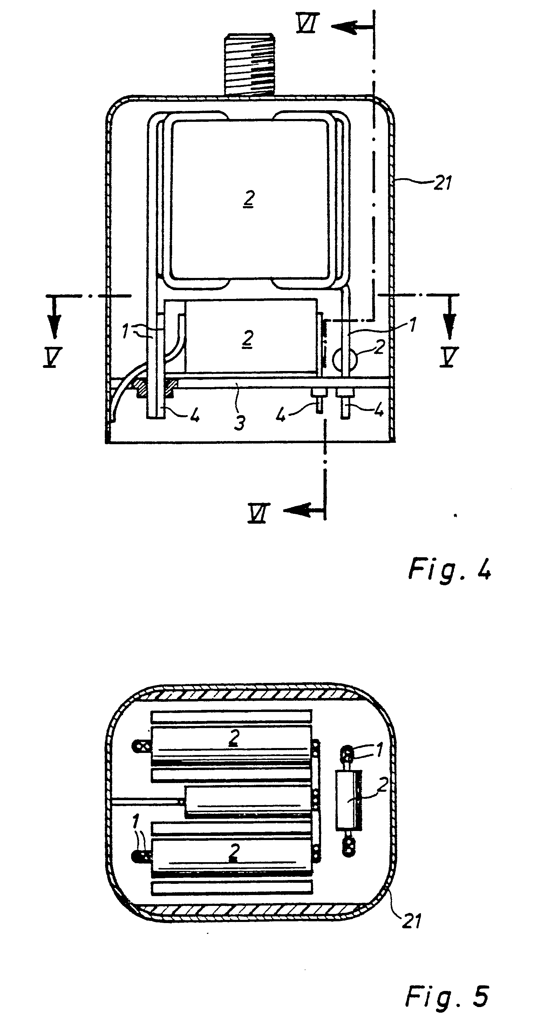

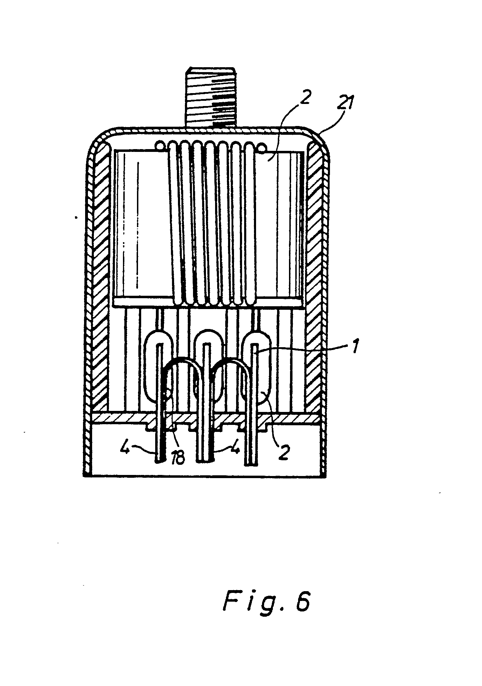

Aus den Fig. 4 bis 6 ist eine andere Anordnung aus elektrischen Bauteilen 2 auf einem Bauteilträger 3 ersichtlich. Hierbei handelt es sich um ein Filter, dessen elektrischen Bauteile 2 aus einer Drossel und aus unter derselben angeordneten Kondensatoren und einem rechts in Fig. 5 dargestellten Widerstand bestehen. Auch hier sind sämtliche elektrischen Bauteile 2, von denen die Filterschaltung gebildet wird, auf der einen Seite des Bauteilträgers 3 angeordnet und mit ihren Anschlußdrähten 1, die senkrecht zur Ebene des Bauteilträgers 3 verlaufen oder in diese Richtung abgewinkelt sind, zu Anschlußdrahtgruppen 4 entsprechend der Filterschaltung zusammengefaßt durch jeweils ein Loch im Bauteilträger 3 hindurchgesteckt, so daß die Anschlußdrähte 1 jeder Anschlußdrahtgruppe 4 in der für ihr Verlöten erforderlichen engen gegenseitigen Anordnung fixiert sind. Wie aus Fig. 6 ersichtlich, sind die beiden äußeren Kondensatoren mit ihrem einen Anschlußdraht 1 mit dem einen Anschlußdraht des mittleren Kondensators jeweils über ein Anschlußdrahtstück 18 elektrisch verbunden. Das Anschlußdrahtstück 18 ist U-förmig gebogen, so daß seine beiden Enden in die gleiche Richtung wie die miteinander zu verbindenden Anschlußdrähte 1 der Kondensatoren weisen. Die Endabschnitte der Verbindungsdrahtstücke 18 sind ebenso wie die durch sie zu verbindenden Anschlußdrähte 1 durch ein Loch im Bauteilträger 3 hindurchgesteckt, so daß die Drahtenden für das Eintauchen in ein Lötbad nach unten vorstehen und dabei das Lötmaterial durch Kapillarwirkung zwischen den zu verbindenden Drähten nach oben gesaugt wird. Die Bauteilanordnung ist in einem Gehäuse 21 angeordnet, in welches sie nach dem Lötvorgang eingesetzt wurde.

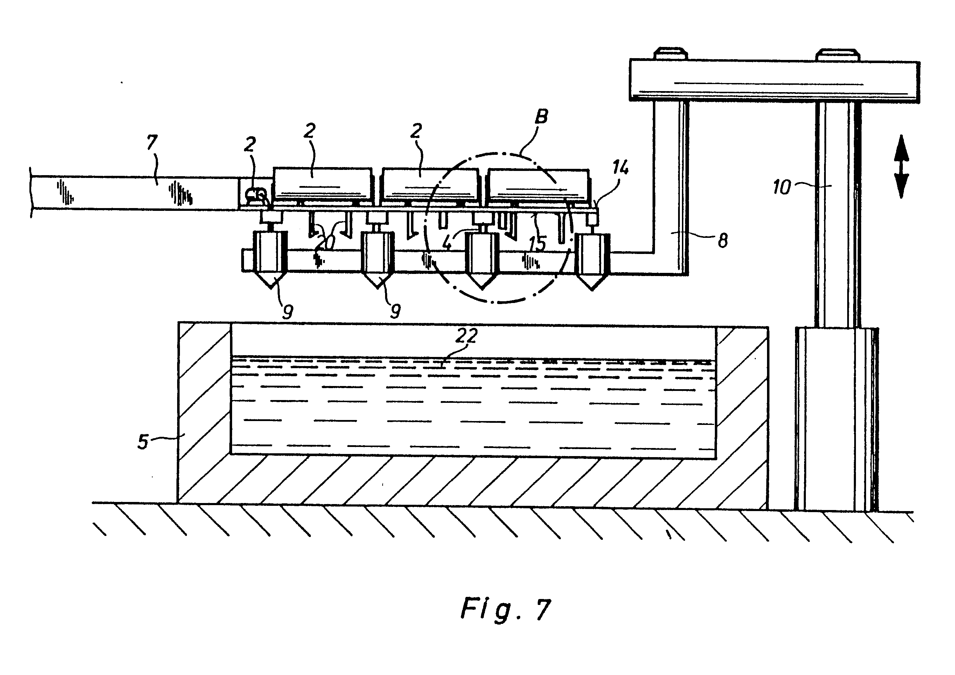

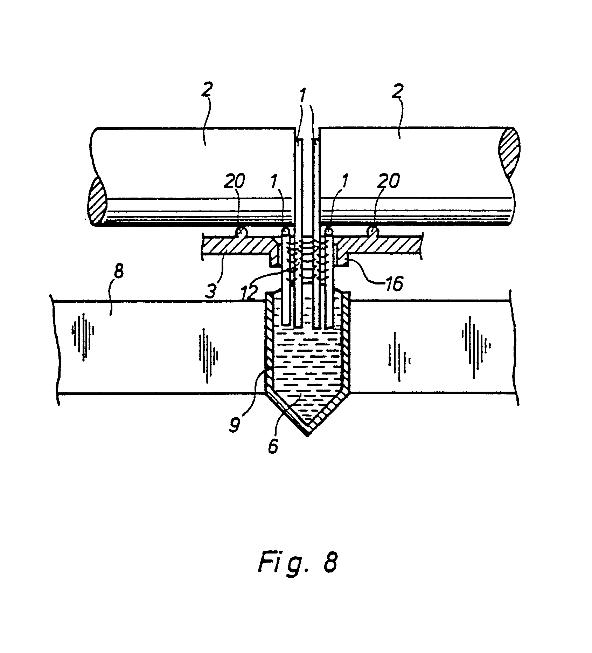

Aus den Fig. 7 und 8 ist ersichtlich, wie das Verlöten der Anschlußdrähte 1 innerhalb jeder Anschlußdrahtgruppe 4 bei der Bauteilanordnung aus den Fig. 1 bis 3 durchgeführt wurde. Die Lötvorrichtung weist eine Haltevorrichtung 7 auf, mit welcher der Bauteilträger 3 mit den auf seiner Oberseite 14 befindlichen elektrischen Bauteilen 2 frei auskragend gehalten werden kann. Unter den in dieser Weise gehaltenen Bauteilträger 3 greift ein Becherhalter 8 mit entsprechend der Anordnung der von der Unterseite des Bauteilträgers 3 nach unten abstehenden Anschlußdrahtgruppen 4 angeordneten Lötbechern 9 ein. Der Becherhalter 8 ist mittels einer Hubvorrichtung 10 aus der in Fig. 7 dargestellten Lötstellung, in welcher die Anschlußdrahtgruppen für das Verlöten der Anschlußdrähte in die Lötbecher 9 eintauchen, und einer unteren Füllstellung verfahrbar, in welcher die Lötbecher gemeinsam in ein Schwallbad 22 aus flüssigem Lötmaterial eintauchen, welches in einem unter den Bechern 9 angeordneten Schmelzenbehälter 5 enthalten ist.

Durch Absenken des Becherhalters 8 in das Schwallbad 22 werden daher die Lötbecher mit frischem Lötmaterial gefüllt, wonach der Becherhalter 8 in die Lötstellung nach oben verfahren wird, so daß — wie aus Fig. 8 ersichtlich — jede Anschlußdrahtgruppe 4 mit ihren freien Drahtenden in die Lotschmelze in einem der Lötbecher 9 eintaucht, wodurch das schmelzflüssige Lötmaterial 12 bis in den Bereich innerhalb des von dem Stutzen 16 des Bauteilträgers 3 umgebenen Loches nach oben gesaugt wird. Da jede zu verlötende Anschlußdrahtgruppe 4 in einen gesonderten Lötbecher 9 eingetaucht wird, der daher entsprechend klein ist, liegt die Wärmeabstrahlung aus dem schmelzflüssigem Lötmaterial in den Lötbechern 9 auf den aus einem Kunststoffmaterial bestehenden Bauteilträger 3 auf einem Minimum, so daß der Bauteilträger 3 aus einem Kunststoffmaterial geringer Warmfestigkeit, beispielsweise aus einem thermoplastischen Material, bestehen kann. Außerdem wird wegen der im Abstand voneinander angeordneten Lötbecher 9 der Lötvorgang nicht durch die von dem Bauteilträger 3 nach unten abstehenden Ansätze 20 behindert, weil diese — wie aus Fig. 7 ersichtlich — in den zwischen den Lötbechern 9 vorhandenen Freiraum eintauchen können.

Die Lötbecher 9 und wenigstens derjenige Teil des Becherhalters 8, der mit den Lötbechern in das Schwallbad 22 im Schmelzenbehälter 5 eingetaucht wird, bestehen aus einem nicht-lötfähigen Material, beispielsweise Stahl, so daß an diesem Material das Lötmaterial nicht haften bleiben kann.

Vor dem Lötvorgang werden die freien Enden der Anschlußdrahtgruppen 4 in ein flüssiges Flußmittel eingetaucht. Dies kann mit einer Vorrichtung durchgeführt werden, die der Lötvorrichtung gleicht und bei welcher in dem Behälter 5 ein Flußmittelbad anstelle des Lötbades enthalten ist. Auch das Flußmittel wird beim Eintauchen der Anschlußdrahtgruppen durch die Kapillarwirkung aus den Bechern 9 in den engen Spalten zwischen den Anschlußdrähten 1 der Anschlußdrahtgruppen 4 nach oben bis in den Bereich innerhalb der Löcher 11 gesaugt, in denen die Anschlußdrahtgruppen zusammengehalten sind.

## Patentansprüche

1. Verfahren zum Verlöten von Anschlußdrähten (1) von elektrischen Bauteilen (2), bei welchem jeweils die miteinander zu verlötenden Anschlußdrähte (1) als Anschlußdrahtgruppen (4), in welchen die Anschlußdrähte (1) mit ihren freien Enden in die gleiche Richtung weisen, gemeinsam in enger gegenseitiger Anordnung in ein Bad (6) aus schmelzflüssigem Lot getaucht werden und das Löten unter Ausnutzung der Kapillarwirkung in Kapillarspalten erfogt, dadurch gekennzeichnet, daß die Anschlußdrähte (1) ausschließlich mit ihren freien Enden in das Bad eingetaucht werden und das Lot in den Kapillarspalten, die aufgrund der engen gegenseitigen Anordnung der Anschlußdrähte (1) zwischen diesen ausgebildet werden, aus dem Bad (6) gesaugt und in den Bereich der Anschlußdrähte (1) über dem Bad zwischen die Anschlußdrähte (1) getrieben wird.

2. Verfahren nach Anspruch 1, bei welchem die elektrischen Bauteile (2) für das Verlöten ihrer Anschlußdrähte (1) auf der einen Flachseite eines Bauteilträgers (3) angeordnet werden und die Anschlußdrähte (1) der Anschlußdrahtgruppe (4) gemeinsam durch ein Loch des Bauteilträgers (3) über dessen andere Flachseite hinausstehend gesteckt und dadurch in ihrer engen gegenseitigen Anordnung gehalten werden, dadurch gekennzeichnet, daß das Eintauchen der freien Enden der Anschlußdrähte (1) in das Lotbad (6) im Abstand unter dem Bauteilträger (3) erfolgt und das Lot unter der Kapillarwirkung bis in das Loch (11) des Bauteilträgers (3) hineingetrieben wird.

3. Verfahren nach Anspruch 2, dadurch gekennzeichnet, daß beim Verlöten der Anschlußdrähte (1) innerhalb von mehreren Anschlußdrahtgruppen (4) diese gleichzeitig in gesonderte Lotbadteile eines gemeinsamen Lotbades eingetaucht werden und diejenige Materialbereiche des Bauteilträgers (3), die zwischen den Anschlußdrahtgruppen (4) liegen, gegen Wärmestrahlung aus dem Lotbad abgeschirmt werden.

4. Verfahren nach Anspruch 2, dadurch gekennzeichnet daß beim Verlöten der Anschlußdrähte (1) innerhalb von mehreren Anschlußdrahtgruppen (4) diese gleichzeitig in voneinander getrennte Lotbäder (6) getaucht werden.

5. Verfahren nach einem der Ansprüche 1 bis 4, dadurch gekennzeichnet, daß zum Herstellen einer Verbindung zweier Anschlußdrähte (1) ein Verbindungsdrahtstück (18) mit seinen beiden Endabschnitten derart an den Endabschnitt jeweils eines der Anschlußdrähte (19) angesetzt wird, daß seine freien Enden in die gleiche Richtung wie diejenigen der beiden Anschlußdrähte (1) weisen, und in dieser Lage mit den Anschlußdrähten (1) verlötet wird.

6. Verfahren nach einem der Ansprüche 1 bis 4, dadurch gekennzeichnet, daß vor dem Anlöten eines Drahtstückes (19) an einen Anschlußdraht (1) das Drahtstück (19) mit seinem einen Drahtendabschnitt derart an den freien Endabschnitt des Anschlußdrahtes (1) angesetzt wird, daß das freie Ende des Drahtendabschnittes des Drahtstückes (19) in die gleiche Richtung wie das freie Ende des Anschlußdrahtes (1) weist.

7. Verfahren nach einem der Ansprüche 2 bis 6, dadurch gekennzeichnet, daß die freien Endabschnitte der Anschlußdrähte (1) der Anschlußdrahtgruppe (4) nach dem Verlöten bis zu der den Bauteilen (2) abgewendeten Flachseite des Bauteilträgers (3) abgetrennt werden.

8. Vorrichtung zum gegenseitigen Verlöten der Anschlußdrähte (1) von elektrischen Bauteilen (2), die auf einem Bauteilträger (3) vormontiert sind und die mit ihren jeweiligen miteinander zu verlötenden Anschlußdrähten (1) als Anschlußdrahtgruppen (4) zusammengehalten sind, zur Durchführung des Verfahrens nach den Ansprüchen 1 und 4, mit einem Schmelzenbehälter (5) zur Aufnahme eines Bades (6) aus schmelzflüssigem Lot und mit einer Haltevorrichtung (7) für den Bauteilträger (3), dadurch gekennzeichnet, daß ein Becherhalter (8) mit mehreren Lötbechern (9) zwischen einer Lötstellung, in welcher die Anschlußdrahtgruppen (4) von der Unterseite des mittels der Haltevorrichtung (7) gehaltenen Bauteilträgers (3) nach unten vorstehend in jeweils einer der Lötbecher (9) eintauchen, und einer Füllstellung verfahrbar ist, in welcher die Becher (9) für ihr Auffüllen in den Schmelzenbehälter (5) eintauchen.

9. Vorrichtung nach Anspruch 8, dadurch gekennzeichnet, daß der Becherhalter (8) zwischen dem Schmelzenbehälter (5) und dem von der Haltevorrichtung (7) im Abstand über dem Schmelzenbehälter (5) gehaltenen Bauteilträger (3) angeordnet ist und eine Hubvorrichtung (10) als Antrieb aufweist.

10. Anordnung aus elektrischen Bauteilen (2), deren Anschlußdrähte (1) mit ihren Drahtenden in die gleiche Richtung weisen und in Anschlußdrahtgruppen (4) nach dem Verfahren nach den Ansprüche 1 und 2 verlötet sind, dadurch gekennzeichnet, daß die elektrischen Bauteile (2) auf der einen Seite eines ihnen gemeinsamen Bauteilträgers (3) angeordnet sind und die verlöteten Anschlußdrahtgruppen (4) jeweils in ein die gegenseitige enge Anordnung ihrer Anschlußdrähte (1) bestimmendes Loch (11) in dem Bauteilträger (3) gesteckt sind und Lötmaterial (12) in den Spalten zwischen den Anschlußdrähten (1) innerhalb des Loches (11) angeordnet ist.

11. Anordnung nach Anspruch 10, dadurch gekennzeichnet, daß an der den Bauteilen (2) abgewendeten Flachseite (15) des Bauteilträgers (3) für jede verlötete Anschlußdrahtgruppe (4) ein das Loch (11) umgebender Stutzen (16) absteht.

12. Anordnung nach Anspruch 11, dadurch gekennzeichnet, daß die verlöteten Anschlußdrähte (1) der Anschlußdrahtgruppen (4) an der freien Stirnfläche (17) der Stutzen (16) enden.

13. Anordnung nach einem der Ansprüche 10 bis 12, dadurch gekennzeichnet, daß die Löcher (11) als schlitzartige Langlöcher ausgebildet sind, in denen die Drahtenden der Anschlußdrähte (1) in einer Reihe angeordnet sind.

### Claims

1. Method of soldering leads (1) of electric components (2) by simultaneously dipping the leads (1) to be mutually soldered in a mutually tight arrangement as groups (4) of leads, in which the leads (1) point with their free ends in the same direction, in a bath (6) of molten solder, wereby the soldering results by way of the capillary effect in capillar gaps, characterized in that the leads (1) are dipped into the bath solely with their free ends, and in that the solder in the capillar gaps formed between the leads (1) because of their mutually tight arrangement is absorbed from the bath (6) and carried between the leads (1) in the regions of the leads (1) above the bath.

2. Method according to claim 1 by arranging the electric components (2) for the soldering of their leads (1) on one plane side of a component carrier (3) and by commonly inserting the leads (1) of the group (4) of leads into a hole of the component carrier (3) so that they project from the other plane side, and therefore are kept in their mutually tight arrangement, characterized in that the dipping of the free ends of the leads (1) into the solder bath takes place at a distance under the component carrier (3), and in that the solder is carried up to the hole (11) of the component carrier (3) by way of the capillary effect.

3. Method according to claim 2, characterized in that for soldering the leads (1) divided in two groups (4) of leads, the latter are commonly dipped into isolated solder bath parts of a common solder bath, and in that those material areas of the component carrier (3) lying between the groups (4) of leads (4) are screened against the thermal radiation emanent from the solder bath.

4. Method according to claim 2, characterized in that for soldering the leads (1) divided into a plurality of groups (4) of leads (4), the latter are simultaneously dipped into different solder baths (6).

5. Method according to one of claims 1 to 4, characterized in that for establishing a connection between two leads (1), a connecting wire (18) is set with its both end portions to the end portions of the respective leads (1) in a way that its free ends point into the same direction as those of the leads (1) and are soldered with the leads (1) in this position.

6. Method according to one of claims 1 to 4, characterized in that before soldering a piece of wire (19) with a lead (1), the piece of wire (19) is set with its one end portion to the free end portion of the lead (1) in such a way, that the free end portion of the piece of wire (19) points into the same direction as the free end of the lead (1).

7. Method according to one of claims 2 to 6, characterized in that the free end portions of the leads (1) of the group (4) of leads are cut off after soldering at the plane side of the component carrier (3) not facing the components (2).

8. Apparatus for the mutual soldering of leads (1) of electric components (2) prearranged on a component carrier (3) and held together by their leads (1) to be mutually soldered as groups (4) of leads, for the purpose of carrying out the method according to claims 1 to 4, comprising a melt receptacle (5) for the reception of a bath (6) of molten solder and a holding device (7) for the component carrier (3), characterized in that a cupholder (8) with a plurality of solder cups (9) is mounted moveably between a soldering position, in which the groups (4) of leads projecting downwards from the underside of the component carrier (3) held by the holding device (7) are dipped in respective one of the solder cups (9), and a filling position, in which the cups (9) dip into the melt receptacle for filling up.

9. Apparatus according to claim 8, characterized in that the cupholder (8) is arranged between the melt receptacle (5) and the component carrier (3) held above the melt receptacle (5) by the holding device (7) and is endowed with a drive developed as lifting device (10).

10. Appliance consisting of electric components (2), the ends of the leads (1) of which show into the same direction and are soldered in groups (4) of leads according to the method according to claims 1 and 2, characterized in that the electric components (2) are arranged on one side of a common component carrier (3), and in that the soldered groups (4) of leads are respectively inserted into a hole (11) in the component carrier (3), said hole determining the mutually tight position of the leads (1), and in that soldering material (12) is arranged in the gaps between the leads (1) within the hole (11).

11. Appliance according to claim 10, characterized in that at the plane side (15) of the component carrier (3) not facing the component parts (2) there is arranged a nozzle (16) projecting from the hole (11) of each soldered group (4) of leads.

12. Appliance according to claim 11, characterized in that the soldered leads (1) of the group (4) of leads end at the free faces (17) of the nozzles (16).

13. Appliance according to claims 10 to 12, characterized in that the holes (11) are developed as slitlike longholes, in which the ends of the leads (1) are arranged in a row.

## Revendications

1. Procédé de brasage de fils de connexion (1) de composants électriques (2), dans lequel on plonge, simultanément et étroitement réunis, dans un bain de brasure fondue (6), les fils de connexion (1) à assembler par brasage, sous la forme de groupes de fils de connexion (4) dans lesquels les extrémités libres desdits fils de connexion (1) sont orientées selon une même direction, le brasage s'effectuant par l'effet de capillarité dans des interstices capillaires, caractérisé en ce qu'on plonge seulement les extrémités libres desdits fils de connexion dans le bain de fusion de brasure, cependant que, dans les interstices capillaires formés entre les fils de connexion du fait de la disposition en étroite juxtaposition desdits fils de connexion (1), la brasure est aspirée à partir du bain (6) et poussée entre les fils de connexion (1), dans la partie de ceux-ci qui est située au-dessus du bain.

2. Procédé selon la revendication 1, dans lequel les composants électriques (2) sont disposés, en vue du brasage de leurs fils de connexion (1), sur une des faces planes d'un support de composant (3), et dans lequel les fils de connexion (1) des groupes de fils de connexion (4) traversent ensemble une ouverture du support de composant (3) de manière à dépasser de l'autre face plane de celui-ci, en étant ainsi maintenus dans leur position d'étroite juxtaposition, caractérisé en ce que l'on plonge les extrémités libres des fils de connexion (1) dans le bain de brasure fondue (6) à une certaine distance au-dessous du support de composant (3), la brasure étant poussée jusque dans l'ouverture (11) dudit support de composant (3) par capillarité.

3. Procédé selon la revendication 2, caractérisé en ce que lors du brasage des fils de connexion (1) à l'intérieur de plusieurs groupes de fils de connexion (4), on plonge ceux-ci simultanément dans des parties séparées d'un bain de fusion de brasure commun, cependant qu'on protège contre le rayonnement calorifique issu dudit bain de brasure les zones du matériau dudit support de composant (3) qui sont situées entre lesdits groupes de fils de connexion (4).

4. Procédé selon la revendication 2, caractérisé en ce que, lors du brasage des fils de connexion (1) à l'intérieur de plusieurs groupes de fils de connexion (4), on les plonge simultanément dans plusieurs bains de brasure fondue (6) séparés les uns des autres.

5. Procédé selon une des revendications 1 à 4, caractérisé en ce qu'afin de relier entre eux deux fils de connexion (1), on applique les deux parties terminales d'un tronçon de fil de connexion (18) à la fois sur les parties terminales d'un tronçon de fils de connexion (19), de façon telle que ses extrémités libres soient orientées selon la même direction que les extrémités libres des deux fils de connexion (1), et en ce qu'on relie ledit tronçon dans cette position aux fils de connexion (1) par brasage.

6. Procédé selon une des revendications 1 à 4, caractérisé en ce qu'avant de fixer par brasage un tronçon de fil (19) sur un fil de connexion (1), on place une des parties terminales du tronçon de fil (19) sur la partie terminale libre du fil de connexion (1) de façon telle que l'extrémité libre de la partie terminale du tronçon de fil (19) soit orientée selon la même direction que l'extrémité libre du fil de connexion (1).

7. Procédé selon une des revendications 2 à 6, caractérisé en ce que les parties terminales libres des fils de connexion (1) du groupe de fils de connexion (4) sont sectionnées après le brasage jusqu'à la face plane du support de composant (3), qui est tournée vers les composants (2).

8. Dispositif pour assembler par brasage les fils de connexion (1) de composants électriques (2) montés préalablement sur un support de composant (3) maintenus ensemble de sorte que leurs fils de connexion respectifs (1) à réunir par brasage forment des groupes de fils de connexion (4), ce dispositif servant à mettre en œuvre le procédé selon les revendications 1 et 4 et comportant un récipient de bain de fusion (5) destiné à contenir un bain (6) de brasure fondue, ainsi qu'un dispositif de maintien (7) dudit support de composant (3), caractérisé en ce qu'un porte-godets (8) associé à une pluralité de godets de brasage (9) est mobile entre une position de brasage dans laquelle les groupes de fils de connexion (4), faisant saillie vers le bas à partir de la face inférieure du support de composant (3) maintenu par le dispositif de maintien (7) précité, plongent chacun dans un godet de brasage (9) respectif, et une position de remplissage dans laquelle les godets (9) plongent dans ledit récipient de bain de fusion (6) en vue de leur remplissage.

9. Dispositif selon la revendication 8, caractérisé en ce que le porte-godets (8) est disposé entre le récipient de bain de fusion (5) et le support de composant (3) maintenu par le dispositif de maintien (7) à une certaine distance au-dessus du récipient de bain de fusion (5), et en ce qu'il comporte des moyens de commande sous la forme d'un dispositif de levage (10).

10. Ensemble formé de composants électriques (2) dont les fils de connexion (1) sont orientés à leurs extrémités selon une même direction et assemblés par brasage par le procédé selon les revendications 1 et 2 pour former des groupes de fils de connexion (4), caractérisé en ce que les composants électriques (2) sont disposés sur une face d'un support de composant (3) commun, cependant que les groupes de fils de connexion (4) assemblés par brasage sont insérés dans des ouvertures (11) respectives ménagées dans le support de composant (3) et déterminant la juxtaposition étroite des fils de connexion (1) intéressés, et que de la brasure (12) est placée dans les interstices définis entre les fils de connexion (1) à l'intérieur desdits ouvertures (11).

11. Ensemble selon la revendication 10, caractérisé en ce que pour chaque groupe de fils de connexion (4) assemblés par brasage, une tubulure (16) entourant l'ouverture (11) intéressée s'étend à partir de la face plane (15) du support de composant (3) qui est tournée vers les composants (2).

12. Ensemble selon la revendication 11, caractérisé en ce que les fils de connexion (1) assemblés par brasage des groupes de fils de connexion (4) se terminent à la face frontale libre (17) des raccords (16).

13. Ensemble selon une des revendications 10 à 12, caractérisé en ce que les ouvertures (11) sont des trous allongés du type fente dans lesquels les extrémités des fils de connexion (1) sont disposées en une rangée.

Fig. 1

Fig. 2

Fig. 3

*Fig. 4*

*Fig. 5*

Fig. 6

Fig. 7

0 166 817

Fig. 8